# EUROPEAN PATENT APPLICATION

(11) **EP 2 169 727 A1**
(43) Date of publication of application: **31.03.2010**
(21) Application number: 09153768.8
(22) Date of filing: 26.02.2009
(51) Int. Cl.: H01L 31/048

(54) **Solar Electric Panel**

(30) Priority: 26.09.2008 SG 200807242
(71) Applicant: Dragon Energy Pte. Ltd., Singapore 048623 (SG)
(72) Inventor: Nightingale, Christopher George Edward, 259983, Singapore (SG); Lee, Wai Hong, 391011, Singapore (SG); Tay, Boon Hou, 438814, Singapore (SG); Goh, Swee Meng, 591401, Singapore (SG); Ang, Teck Wee, 390049, Singapore (SG)
(74) Representative: Stones, James Alexander

(57) **Abstract**

A solar panel (400) comprises: a base tile (100), a plurality of photovoltaic tiles (10), a connection system (200), for each photovoltaic tile (10) one or more electrical bypass devices (42). Each photovoltaic tile (10) comprises one or more photovoltaic cells (12) electrically connected together to form a photovoltaic cell circuit (40). The connection system (200) is supported by or on the base tile (100), and electrically connects the photovoltaic tiles (10) together in groups of two or more photovoltaic tiles, and mechanically couples the photovoltaic tiles (10) to the base tile (100). At least one bypass device (42) is shunted across a set of one or more of the photovoltaic cells (12) in the photovoltaic cell circuit (40).

## Description

### Field of the Invention

The present invention relates to a solar electric panel particularly, though not exclusively, for use on a roof of a building to provide electrical energy for the building.

### Background of the Invention

It is well known to use solar electric panels to provide power to electrical apparatus or storage devices. Depending on the specific application at hand, the panels may be either free-standing or applied to a roof of a building. When the panels are applied to a roof of a building, they may typically overlie an existing roof covering.

Applicant has previously devised a photovoltaic tile assembly for converting solar energy to electricity. The photovoltaic tile assembly is configured in a manner so that it can also act as a roof covering and thereby be used in place of traditional roof coverings such as tiles, slate and iron.

Further details of Applicant's above-described photovoltaic tile assembly are provided in Singapore patent application No. 200716871-9.

### Summary of the Invention

In one aspect, the present invention provides a solar electric panel comprising:
a base tile;
a plurality of photovoltaic tiles, each photovoltaic tile comprising one or more photovoltaic cells electrically connected together to form a photovoltaic cell circuit;
a connection system supported on or in the base tile, the connection system electrically connecting the photovoltaic tiles together in groups of two or more photovoltaic tiles, and mechanically coupling the photovoltaic tiles to the base tile, the connection system being configured to facilitate electrical coupling of the base tile with an adjacent base tile; and
at least one bypass device shunted across a set of one or more of the photovoltaic cells in the photovoltaic cell circuit, wherein the bypass device provides a current path for the photovoltaic cell circuit across the set of photovoltaic cells when an output voltage across the set of photovoltaic cells is less than a predetermined threshold voltage.

The connection system may comprise:
a plurality of conducting posts, each post having a free end to which the photovoltaic tiles are coupled; and,
a plurality of electrical conductors that electrically connect the posts together.

The connection system may comprise a first electrical connector and a complementary second electrical connector wherein the first electrical connector is coupled to an end of the electrical conductor connected to a first of the posts and the second electrical connector is coupled to an end of the electrical conductor connected to a last of the posts whereby the first electrical connector of one electrical connection system can be electrically connected with a second electrical connector of a second electrical connection system to provide electrical continuity between the first and second electrical connection systems.

One or both of the first and second electrical connectors may be provided with a degree of resilience so as to apply a mechanical force between first and second electrical connectors when coupled together, the mechanical force acting to maintain coupling between the first and second electrical connectors.

The first and second electrical connectors may also be configured to form, when engaged with each other, a mutual contact surface of variable length.

The free end of each post may be provided with a fitting to enable mechanical and electrical connection to the photovoltaic tile.

The fitting may comprise a plurality of resilient, or resiliently supported, radially extending projections, formed about the free end of the post.

In an alternate embodiment the fitting may comprise a combination of (a) a screw thread formed on the free end of the post and a nut adapted to be screwed onto the thread, or (b) a screw thread formed in the free end of the post and a screw or bolt adapted to be screwed onto the thread.

In one embodiment of the solar panel the electrical conductors and posts are encapsulated to form an electrical connection tile, wherein the free end of each post is accessible to facilitate connection with the photovoltaic tiles.

In one form of the connection system each electrical conductor comprises a conducting rail to which a plurality of the posts is connected.

However in an alternate form of the connection system each electrical conductor comprises one or more wires, or one or more conducting tracks on a circuit board. In this form, the wires or tracks are configured to enable custom connection to the posts to provide selectable connection configurations. For example the wires or tracks may be configured to provide a series connection between the one or more first electrical devices or apparatuses.

The base tile may be made from a moldable material and the connection system is molded into the substrate.

In an alternate embodiment the base tile comprises a bottom shell defining a cavity in which the connection system is disposed. In this embodiment the base tile comprises a top shell which overlies the cavity and is provided with a plurality of holes in alignment with the posts wherein the posts extend toward corresponding holes.

The base tile may comprise a plurality of markers on a first surface each marker positioned at a location whereby a mechanical fastener passing through a marker in a plane perpendicular to a plane containing the base tile is spaced from the connection system.

The base tile may also comprise a sealing system for providing a waterproof seal between adjacent abutting base tiles.

Each photovoltaic tile may comprise:
a carrier tile having a first side; and
a cover plate sealed to the carrier tile, the cover plate having a first side, wherein the carrier tile and the cover plate are relatively configured to form a recess therebetween when cover plate overlies the carrier tile with the respective first sides facing each other, wherein the one or more photovoltaic cells are seated in the recess.

In one form of the panel, the photovoltaic tile, when viewed from a side provided with the cover plate may have a slate-like appearance.

In addition the carrier tile may be of a slate-like colour.

The photovoltaic cells may also be of a slate-like colour.

The cover plate may have substantially the same footprint as the carrier tiles so that respective edges of the carrier tile and cover plate are substantially co-terminus.

In one embodiment the recess may be formed in the first surface of the carrier tile. In this embodiment the cover plate can be seated in the recess.

The photovoltaic tiles may comprise one or more through hole electrical terminals by which the photovoltaic tiles are electrically and mechanically coupled by the connection system.

The photovoltaic tiles may further comprise electrical cell conductors providing an electrical connection between each electrical terminal and the one or more photovoltaic cells.

The electrical cell conductor may be molded into the carrier tile for at least a portion of their length extending from the terminals.

Each bypass device comprises a switching device.
At least one of the bypass devices may be a diode.
At least of the one diodes is selected to have a forward voltage drop of equal to or less than 0.7 V.
In one form of the panel, at least one switching device is an anti-fuse or a transistor switching device.
At least one diode may be shunted across one or more of the photovoltaic cells in a manner such that each diode is reverse biased by the one or more photovoltaic cells across which it is shunted.

The at least one bypass device may be thermally insulated so as to reduce leakage current therefrom.

### Brief description of the Drawings

Figure 1 is a partial exploded view from the top of a solar electric panel in accordance with a first embodiment of the present invention;
Figure 2 is an exploded view from the bottom of a base tile incorporated in the solar electric panel shown in Figure 1;
Figure 3 depicts a method of attaching the solar electric panel to a supporting structure;
Figure 4 is a view of section AA of the base tile shown in Figure 2;
Figure 5 is a pan view of two base tiles side by side;
Figure 6 is an isometric view of a corner of a two base tiles prior to joining to each other;
Figure 7 is a cross section view of two base tiles connected to a supporting structure;
Figure 8 is a side view of solar electric panel;
Figure 9 is an enlarged isometric view of a corner of the solar electric panel;
Figure 10 is a representation of one form of connection system incorporated in the solar electric panel when electrically connecting two solar electric panels together;
Figure 11 is a further representation of the connection system;
Figure 12 is an enlarged view of one form of fitting of the connection system to mechanically couple a photovoltaic tile of the solar electric panel to a base tile;
Figure 13 is an equivalent circuit diagram of the connection system shown in Figures 10 and 11;
Figure 14 is an enlarged view of a second form of fitting of the connection system to mechanically couple a photovoltaic tile of the solar electric panel to a base tile;
Figure 15 is an enlarged view of a third form of fitting of the connection system to mechanically couple a photovoltaic tile of the solar electric panel to a base tile;
Figure 16 is depicts an alternate form of base tile and connection system incorporating a forth form of fitting to mechanically couple a photovoltaic tile of the solar electric panel to a base tile;
Figure 17 is an exploded view of the base tile and connection system shown in Figure 16;
Figure 18 is an equivalent circuit diagram of the connection system shown in Figures 16 and 17;
Figure 19a is a representation of one form of photovoltaic tile incorporated in the solar electric panel;
Figure 19b is an exploded view of the photovoltaic tile shown in Figure 19a;
Figure 19c is a schematic representation of a carrier tile incorporated in the photovoltaic tile depicted in Figures 19a and 19b;
Figure 20a is a representation of a second form of photovoltaic tile incorporated in the solar electric panel;
Figure 20b is an exploded view of the tile shown in Figure 20a;
Figure 20c is a schematic representation of a carrier tile incorporated in the photovoltaic tile depicted in Figures 20a and 20b;
Figure 21 is a representation of a portion of a roof covered by a plurality of solar electric panels;
Figure 22 is a cross section of one form of sealing system incorporated in the photovoltaic tile;
Figure 23 is a cross section of a second form of sealing system incorporating in the photovoltaic tile;
Figure 24 shows a perspective view of a photovoltaic tile having a photovoltaic cell circuit composed of a 3x3 matrix of series connected photovoltaic cells;
Figure 25 shows a graph of the open circuit voltage of the photovoltaic cell circuit of Figure 24 as a function of the number of photovoltaic cells that are shaded from impinging light;
Figure 26 shows a circuit diagram of the photovoltaic cell circuit of Figure 24 incorporated in a test circuit;
Figure 27 shows a bypass device shunted across one photovoltaic cell of the photovoltaic cell;
Figure 28 shows a circuit diagram of the photovoltaic cell circuit of Figure 27 having the shunted photovoltaic cell shaded from impinging light;
Figure 29 shows a bypass device shunted across all of the photovoltaic cells of the photovoltaic cell; and
Figure 30 is a circuit diagram showing a series connection of two shunted photovoltaic cell circuits of the type shown in Figure 29.

### Description of Embodiments

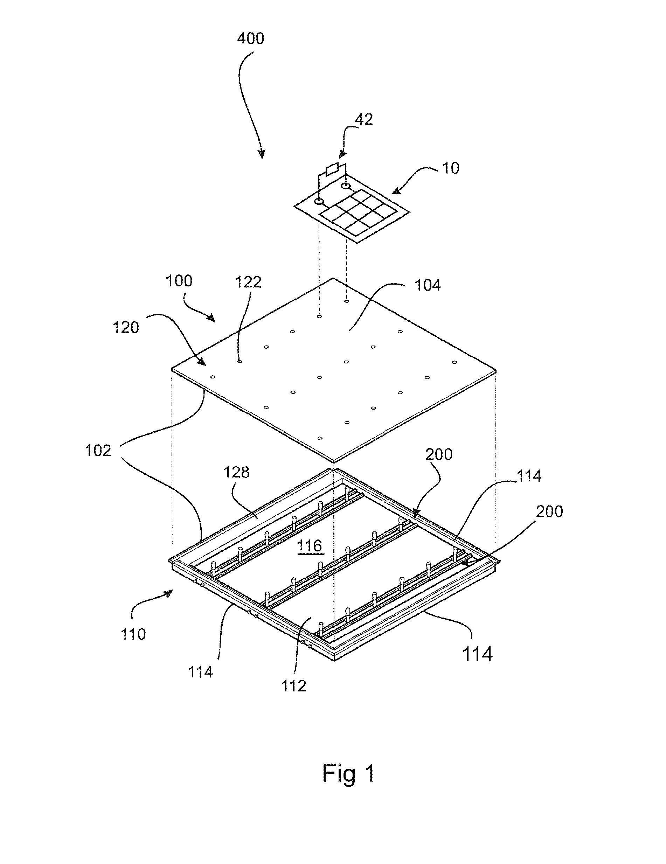

Figure 1 is a schematic representation of an embodiment of a solar panel 400. The solar panel 400 comprises: a base tile 100, a plurality of photovoltaic tiles 10 (only one shown in this Figure), a connection system 200, for each photovoltaic tile 10 one or more electrical bypass devices 42. More particularly each photovoltaic tile 10 comprises one or more photovoltaic cells 12 electrically connected together to form a photovoltaic cell circuit 40. The connection system 200 is supported by or on the base tile 100, and electrically connects the photovoltaic tiles 10 together in groups of two or more photovoltaic tiles, and mechanically couples the photovoltaic tiles 10 to the base tile 100. In addition the connection system is configured to facilitate electrical coupling of the base tile 100 with an adjacent base tile. At least one bypass device 42 is shunted across a set of one or more of the photovoltaic cells 12 in the photovoltaic cell circuit 40. Each bypass device 42 provides a current path for the photovoltaic cell circuit 40 across the set of photovoltaic cells 12 when an output voltage across the set of photovoltaic cells is less than a predetermined threshold voltage. As explained in greater below this reduces voltage drop the solar panel 400 in the event the voltage output an individual cell 12 is reduced so as to act as a high impedance or effective short circuit, which may arise for example due to the shadow effect.

The panel 400 may be connected to a plurality of adjacent panels 400 to provide increased electrical output. The panel 400 may be deployed in say an array supported by a ground based frame. Alternately the panel may be mounted on a roof of a building and connected to an electrical power management system to provide power to electrical devices in the building.

Various components of the photovoltaic tile will now be described in greater detail.

### Base Tile 100

With reference to Figures 1-9, one possible form of the base tile 100 comprises a substrate 102 having which supports or holds the electrical connection system 200. While the connection system 200 is described in greater detail later, a brief description is provided now to aid in the understanding of the structure and function of the base tile 100. The connection system 200 comprises a plurality of electrically conducting posts 204 connected together by electrical conductors 202. Each post 204 has a free end 206 that can be accessed from or extends beyond a first surface 104 of the substrate 102. This enables and facilitates both electrical connection of the photovoltaic tiles 10 together and mechanical coupling of the photovoltaic tiles 10 to the base tile 100.

In this embodiment the substrate 102 comprises a bottom shell 110 having a planar bottom surface 112, and a peripheral wall 114 extending about the bottom surface 112. The bottom surface 112 and the peripheral wall 114 define a cavity 116 in which the conductors 202 are disposed.

Optionally, the cavity 116 may be filled with an insulating material to provide thermal insulation through the base tile assembly 110.

When the substrate 102 is formed with the bottom shell 110, it may also be provided with a top shell 120 that overlies the cavity 116 and is provided with a plurality of holes 122 through which the free ends 206 of the posts 204 extend. The surface of the top shell 120 opposite the cavity 116 forms the first surface 104 of the base tile 100. Top shell 120 is sealed to the bottom shell 110 to prevent the ingress of water into the cavity 116. This may be achieved by the use of mechanical seals, sealants, adhesives, or ultrasonic welding. Use of ultrasonic welding is particularly suitable when the substrate 102 is made from a plastics material.

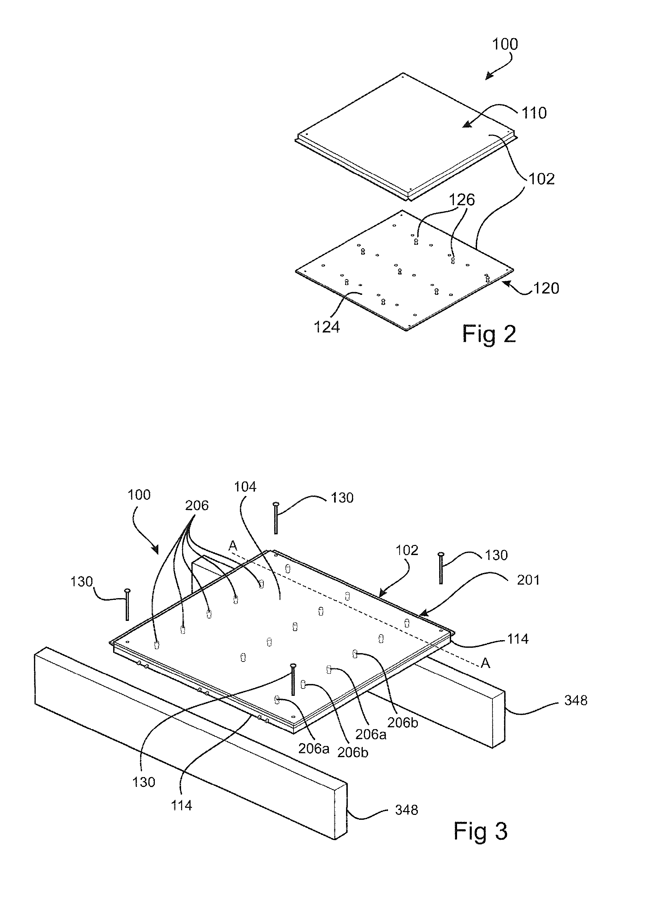

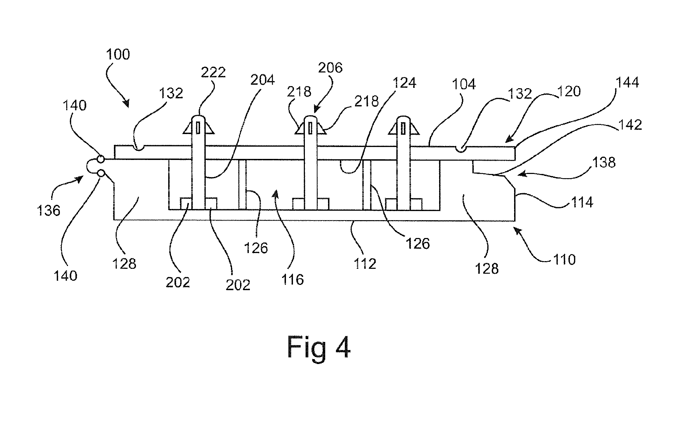

In order to provide a degree of compression resistance to the base tile 100, a surface 124 of the top shell 120 which faces the cavity 116 is provided with a plurality of depending legs or struts 126 (see Figures 2 and 4). The legs 126 bear against the bottom surface 112 when the top shell 120 is attached to the bottom shell 110.

The bottom shell 110 is provided with two solid benches or strips 128 that extend on the inside of the cavity 116 parallel to each other and on opposite sides of the shell 110. When the solar panel 400 is used as in a roof based energy system, the base tile 100 may be fixed to rafters 348 of the roof by mechanical fasteners such as nails or screws 130 that are driven through the thickened strips 128. In order to ensure a user drives the nails or screws 130 through the strips 128 and therefore avoids the electrical connection system 200, the top shell 120 is provided with four markers 132, one in each corner. The markers 132 may be in the form of: a simple indelible mark made on the first surface 104; indentations; or, through holes.

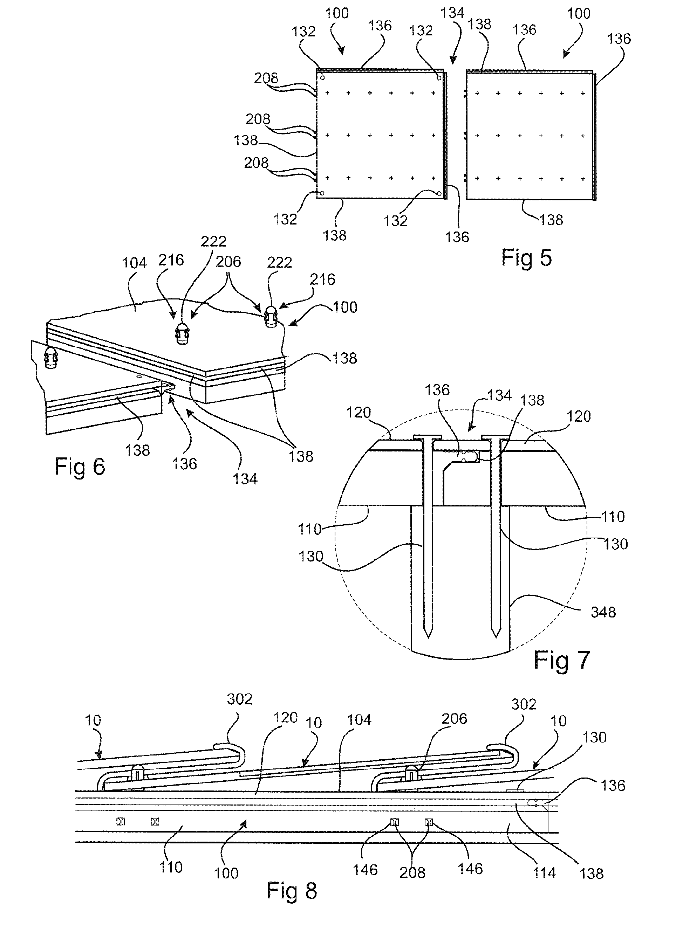

Base tile 100 is provided with a tile sealing system 134 for providing a waterproof seal between adjacent abutting base tiles 100. With particular reference to Figures 4-7, the tile sealing system 134 in this embodiment comprises laterally extending tongues 136 that run along two adjacent sides of the base tile 100 and to longitudinal grooves 138 that run along the two remaining sides of the base tile 100. The tongues 136 are formed integrally with the bottom shell 110 as shown most clearly in Figures 4 and 7. Rubber sealing strips 140 are partially embedded in, and on opposite sides of, each tongue 136. Each groove 138 is formed as a space between the bottom shell 110 and the top shell 120. More particularly, with reference to Figure 4, it can be seen that the groove 138 is formed as the combination of a rebate 142 formed in one of the peripheral walls 114 and an overhanging portion 144 of the top shell 120. When the tongue 136 of one base tile assembly is inserted into the groove 138 of an adjacent tile assembly a waterproof seal is formed between the respective adjacent base tiles 100.

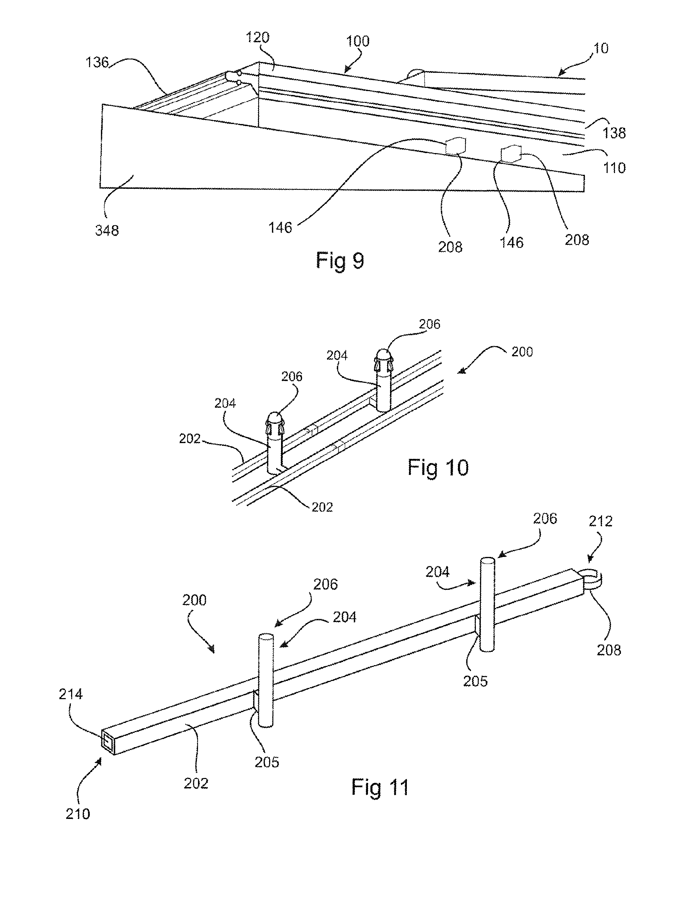

The substrate 102 and more particularly the bottom shell 110 is provided with a plurality of holes 146 along opposite peripheral walls 114 to allow electrical connection between the electrical conductors 202 when adjacent base tiles 100 are coupled together. Figures 8 and 9 depict the holes 146 formed in the peripheral wall 114 containing the groove 138. Ends of the conductors 202 extend through the holes 146. Corresponding holes are formed in the peripheral wall 114 on the opposite side of the bottom shell 110 which are in alignment with the holes 146 on an adjacent base tile. Thus when two base tiles 100 are coupled together, the connection system 200 in each tile 100 are also electrically coupled together.

### Connection System 200

Figures 10-12 depict one form of the connection system 200 where the electrical conductors are in the form of rails 202 to which a plurality of electrically conducting posts 204 is connected. In this embodiment, each rail 202 is in the general form of a square section metallic tube or rod. The posts 204 extend parallel to each other and perpendicular to the rail 202. Each post 204 is coupled to the rail 202 by a short transverse link 205. In one embodiment, the posts 204 may be welded, brazed or soldered to the links 205 which may be formed integrally with the rail 202. Alternatively the links 205 may be formed separately and subsequently attached to the rail 202. In a further variation it is possible for the posts 204 to be provided with a detachable coupling for connecting to the links 205. In yet a further variation the rail 202 and posts 204 may be integrally formed.

A male connector 208 and female connector 210 at opposite ends of the rail 202 constitute one form of complementary connectors that may be utilized in the connection system 200 to enable electrical connection between adjacent rails 202. In this embodiment, the male connector 208 is in the form of two spring arms 212 formed at one end of a rail 202, while the female connector 210 is in the form of a simple hole 214 at the opposite end of the rail 202. The spring arms 212 and the hole 214 are relatively configured so that when the spring arms 212 are inserted into the hole 214 they provide a degree of resilience to apply a mechanical bias force. This acts to provide both mechanical and electrical coupling between adjacent rails 202.

Numerous different types of configuration of electrical connectors may be provided at the opposite ends of each conductor (rail) 202. For example, the spring arms 212 may be replaced with a banana plug type connector. Alternatively, the connector 208 may be provided with one or more sprung contact balls which contact the inside surface of the hole 214. Indeed, the inside surface of the hole 214 may also be provided with complementary shaped recesses for receiving corresponding sprung balls. This will provide a snap-type fitting.

In the connection system 200 shown Figures 1, 4 and 10 the rails 202 are arranged in pairs. This enables respective rails in the pair to act as a nominal positive rail and a nominal negative rail. Further, as shown in the above mentioned figures together with Figure 3, the rails 202 in each pair are arranged so that their respective posts 204 are alternatively disposed in a direction parallel to the rails 202, and more particularly are in mutual alignment. For example with reference to Figure 3, which shows the free ends 206 of post 204 extending above the surface 104 of a base tile 100, each second free end 206a in a bottom row 201 is connected to the same rail 202, with each interleaving pair of post 206b coupled to the other rail in the rail pair. Thus when a photovoltaic tile 10 is mounted on a base tile 100 the terminals 28 and 30 of the tile 10 are electrically coupled with posts 204 of different rails 202 in a rail pair.

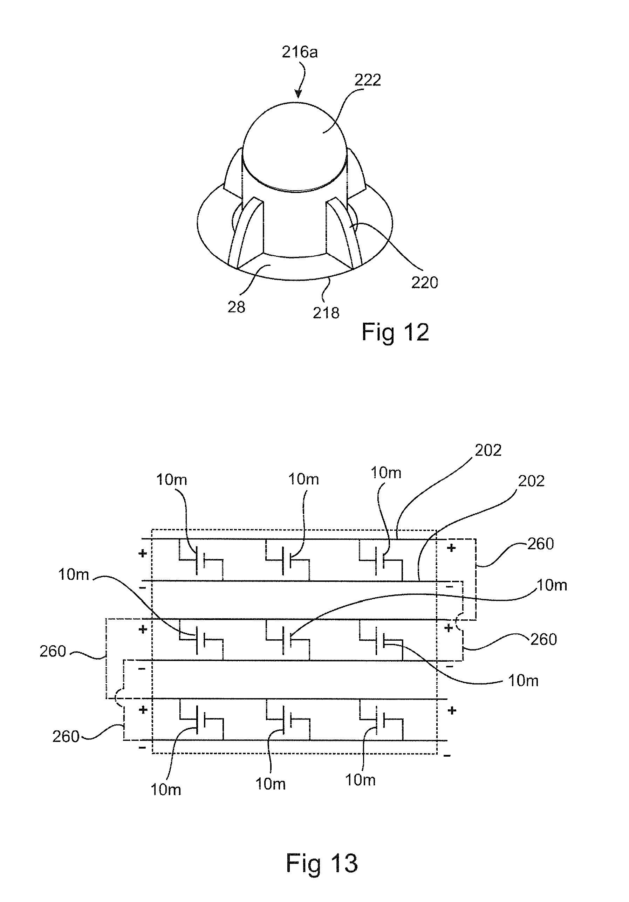

Figure 13 (ignoring the phantom connections 260 for the time being) shows an equivalent circuit of the connection system 200 where the photovoltaic tiles 10 are modeled as 4.5v voltage sources 10m. The rails 202 of each pair provide a parallel connection for the connected tiles 10. Thus one base tile 100 will provide three independent "banks" of parallel connected tiles 10. The pairs of rails in one base tile connect to corresponding pairs of rails on adjacent base tiles 100. This provides an extended parallel connection of the tiles 10 along the base tiles 100. However in a minor variation the connection system may be modified to provide a series connection between the three pairs of rails in each base tile 100 thus providing a series connection of three banks of parallel connected tiles 10 (which is equivalent to all of the tiles 10 being connected together in parallel with each other on one and the same base tile 100). This is depicted by the phantom connections 260 in Figure 13.

In the connection system 200 and as shown in Figures 4, 6, 8, and 10-12 the free end 206 of each post 204 extends above the first surface 104 of the base tile 100. The free end 206 is provided with a fitting 216 to enable electrical connection and mechanical coupling of a photovoltaic tile 10. The photovoltaic tile 10 is provided with through hole terminals 28 and 30. The construction of the photovoltaic tile 10 is described in greater detail later.

Four different forms of fitting 216 are described in this specification, however those skilled in the art will appreciate that any other specific construction of fitting 216 that performs the same function as the embodiments described hereinafter can of course be used with other embodiments the present invention.

One form of fitting 216a which comprises a plurality of resilient or resiliently supported radially extending projections in the form of fins or barbs 218 is shown in Figures 4, 6 and 10-12. Here, four fins 218 are shown evenly disposed about the free end 206 of the post 202. Each fin is formed with a rounded upper shoulder 220 and is spring biased outward of the post 204. That is, the fins 218 can be moved in a radial inward direction against the spring bias to allow the free end 206 to pass through, for example, the through hole terminal 28. Once the free end 206 is passed through the connector 28, the fins 218 extend radially outward by action of a spring and their lower surface bears on and thus make electrical contact with the terminal 28.

The fins 218 also provide mechanical coupling to retain the photovoltaic tile 10 on the base tile 100. In order to mechanically separate the photovoltaic tile 10 from the post 204, the fins 218 must be pushed radially inward against the spring to an extent that collectively they circumscribe a circle having a diameter smaller than an inner diameter of the terminal.

A resilient cap 222 is fitted to the top of the free end 206 to provide a degree of cushioning to an overlying photovoltaic tile 10.

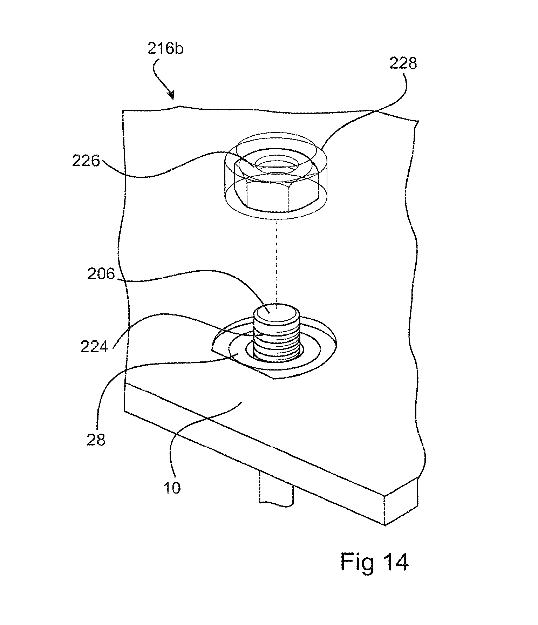

Figure 14 depicts a second form of fitting 216b which comprises the combination of a screw thread 224 formed about the free end 206 of a post 204, and a threaded cap 226 that can be screwed onto the thread 224. The cap 226 is made from an electrically conducting material. In one variation, in order to minimize the risk of the ingress of water and possible corrosion to both the fitting 216b and the terminal 28, the nut 226 may be formed with a blind hole rather than a through hole.

In a further variation or modification, the nut 226 may be embedded or carried by a cap 228. In one form, the cap 228 may be formed of a transparent or translucent plastics material. This may assist installers in lining up the nut 226 with the post 204. A waterproof seal in the form of an O-ring may also be embedded in a bottom surface of the cap 228, to form a seal against the terminal 28 to prevent the ingress of water and thus minimize the risk of corrosion of the terminal 28 and the fitting 216b. Alternatively, the entire cap 228 may be formed of a resilient material.

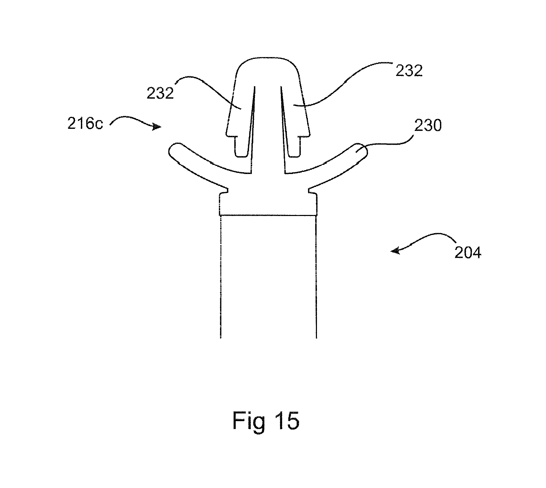

Figure 15 depicts a further variation of the fitting 216c. In this embodiment, the fitting 216c comprises the combination of a radially extending spring 230 which extends from opposite sides of the free end 206, and a pair of electrically conducting fingers 232 spaced above the spring 230. The fingers 232 are resiliently supported so that they may be sprung radially inward to enable them to pass through the through hole terminal 28. Thus in order to couple a photovoltaic tile 10 to a post 204 provided with a fitting 216c, the fingers 232 are sprung inwardly as the photovoltaic tile 10 is pushed onto the free end 206. The spring 230 is deflected downwardly during this process. When the tile 10 has been pushed down so that the fingers 232 are now clear of the terminal 28, they release to spring outwardly to an extent beyond the internal diameter of the terminal 28. The spring 230 applies a bias on the underside of the photovoltaic tile 10 to thereby assist in maintaining electrical contact between the fingers 232 and the terminal 28.

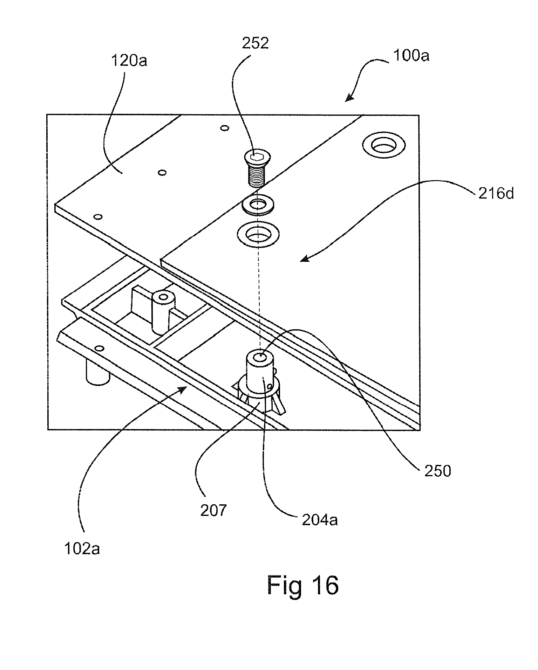

Figures 16, 17 and 18 depict an alternative form for fitting 216d and corresponding alternate form of base tile 100a and connection system 200a. The fitting 216d comprises a threaded bore 250 provided axially in each post 204a and a corresponding threaded screw or bolt 252 having a shank that passes through the electrical terminals 28 and 30 of a photovoltaic tile 10. The fitting 216d thus provide electrical connection between the photovoltaic tile 10 and the connection system 200a, while also mechanically securing the tile 10 the base tile 100a.

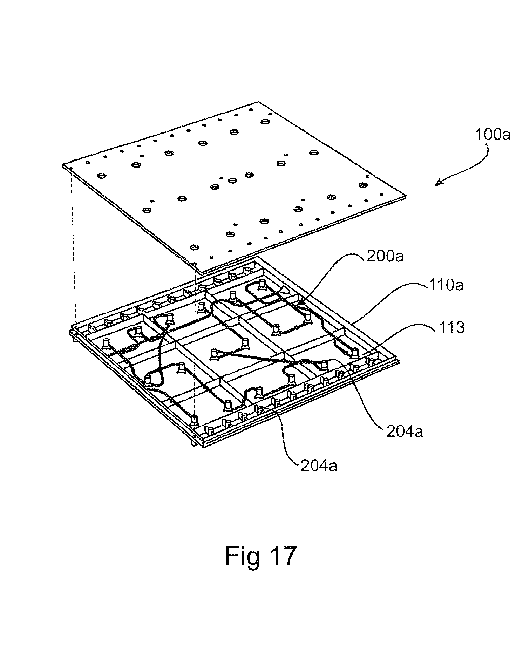

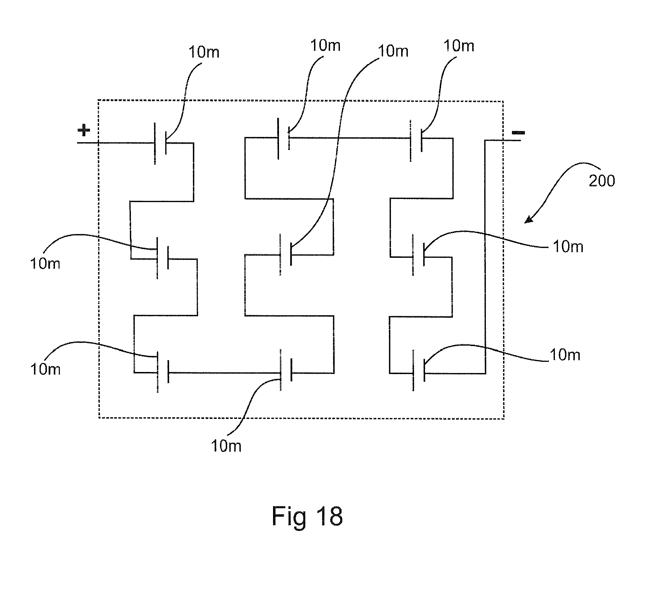

In this form of the connection system 200a the electrical conductors are in the form of wires 202a rather than rails 202. The use of wires 202a enables electrical connection of the posts 204a in a customized manner to provide a desired electrical connection configuration. For example as shown in Figures 17 and 18 a series connection of all photovoltaic tiles 10 (modeled as voltage sources 10m in Figure 18) can be achieved to provide greater output voltage. The wires may be connected to the posts by soldering or brazing. When this form of the electrical connection system is used with the base tile 100a, a plurality of bosses 113 may be formed on and extending upward from an inside surface of the bottom shell 110a into which the posts can be press or interference fit.
The press or interference fit can also provide an alternate connection mechanism, where the wire is in effect clamped between the boss and post to provide an electrical connection. If desired the cavity 116 can be filled with an encapsulating resin.

In a variation to the embodiment where the conductors are in the form of wires, the wires and posts may be pre-connected to provide the desired circuit configuration, with the posts held in the required position to enable connection to the photovoltaic tiles 10, then encapsulated to form an electrical connection tile that can be dropped into the cavity 116. As an alternative to encapsulating, the base tile could be molded about the pre-connected wires 202a and posts 204a to form an integrated tile and connection system.

In yet a further alternative the electrical conductor can be in the form of one or more conductive tracks formed on a circuit board, with the posts subsequently soldered or brazed to the circuit board. The board can then be dropped into the cavity 116. Prior to doing this the entire board can be encapsulated for example in a resin/epoxy to form an electrical connection tile that can provide thermal insulation for the base tile 100a. When the posts 204a are used in conjunction with the fittings 216d the posts can be made of a length to extend between the inside surface of the bottom shell 110 and the inside surface of the top shell 120. In this way the posts can also provide mechanical strength to the base tile 100.

When the electrical conductors are in the form of wires or tracks on a circuit board complimentary electrical connectors identical or similar to the male and female connectors 208 and 210 may be attached to opposite ends of the circuit formed by the connected wires or tracks to facilitate electrical connection between connection systems of adjacent panels 400.

While the posts 204 are described and illustrated as extending perpendicular to its corresponding rail 202 this need not be the case. For example, the posts 204 may extend diagonally of, or in the same plane as, the rails 202. Additionally, there is no requirement for the posts 204 of a rail to extend in the same direction to each other (i.e., to be parallel). For example if desired alternating posts 204 attached to the same rail 202 may extend in different directions. Further, the posts 204 may be provided on both sides of the rail 202.

### Photovoltaic Tiles 10

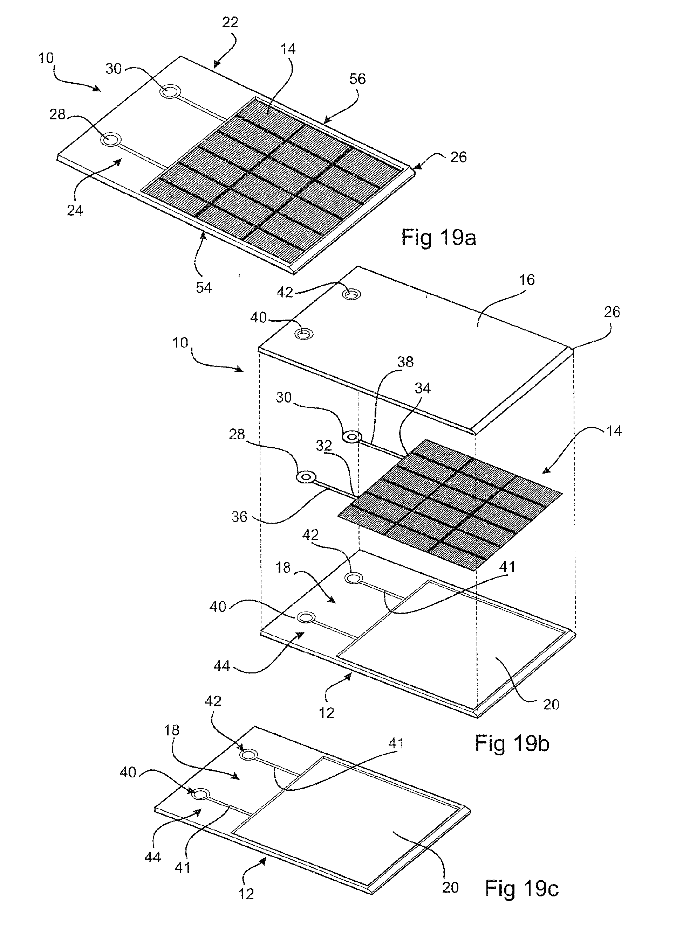

Figures 19a-19c, depict one form of the photovoltaic tile 10 that may be used in the solar electric panel 400. The tile 10 comprises a carrier tile 12 and one or more photovoltaic cells 14. The carrier tile 12 has a first side 18 on which a recess 20 is formed. The photovoltaic cells 14 are formed a single unit which is dimensioned relative to the recess 20 to seat in the recess 20. A cover plate 16 overlies the photovoltaic cells 14 and can be sealed to the carrier tile 12. In this particular embodiment the cover plate 16 has substantially the same footprint as the carrier tile 12, and is juxtaposed so that the edges of the plate 16 and the tile 12 are co-terminus.

A front or exposed face 22 of the photovoltaic tile 10 is provided with a flat surface 24. The formation of the flat surface 24 is achieved by forming the thickness of the photovoltaic cell 14 to be substantially the same as or less than a depth of the recess 20, and providing the cover plate 16 with a flat upper surface.

When the solar electric panels 400 are used as a roof covering on a house or other building the photovoltaic tile 10 can be made to have a slate-like appearance, i.e., a slate-like colour to blend in with surrounding houses and buildings that may be provided with slate or shingle roofs. This may be achieved by forming the carrier tile 12 of a slate-like colour. Additionally, the photovoltaic cell 14 can be formed to be substantially clear so that the slate-like colour of the underlying carrier tile 12 is visible through the photovoltaic cell 14; or, by forming the photovoltaic cell 14 to also be of a slate-like colour. The cover plate 16 is made of a transparent material to maximize transmission of solar energy to the cell 14. This also enables the slate-like colour of the underlying carrier tile 12 and/or photovoltaic cell 14 is visible therethrough.

Edges of the cover plate 16 may be sealed to a peripheral edge of the carrier tile 12 by use of sealants, adhesives, or ultrasonic welding.

A lower edge or strip 26 of the photovoltaic tile 10 which consists of the lower edge of the cover plate 16 is formed with a curved or rounded cross-section. It is believed that this may assist in reducing uplift or the effect of uplift in windy conditions.

In order to collect or otherwise use electricity generated by the photovoltaic cell 14, the photovoltaic tile 10 is provided with electrical terminals 28 and 30. The terminals 28 and 30 are electrically coupled with electrical contacts 32 and 34 of the photovoltaic tile 14 by respective conductors or bus bars 36 and 38. Each terminal 28 and 30 is in the form of a ring terminal which circumscribes respective holes 40 and 42 formed in the photovoltaic tile 10. In particular, each hole 40 and 42 is formed in a portion 44 of the carrier tile 12 that does not contain the recess 20.

The bus bars 36 and 38 are electrically coupled to their respective terminals 28 and 30 by any suitable means such as by soldering. During the construction of the photovoltaic tile 10, the terminals 28 and 30 and the bus bars 36 and 38 can be attached to the photovoltaic cell 14. Recesses or grooves 20 are formed in the carrier tile to seat the terminals and bus bars when the a photovoltaic cell 14 is seated in the recess 20 Thereafter, the cover plate 16 is placed over the photovoltaic cell 14 and sealed onto the carrier tile 12. Thus the terminals 28 and 30, and the bus bars 36 and 38 are embedded in the photovoltaic tile 10 by way of being sandwiched between the cover plate 16 and the carrier tile 12.

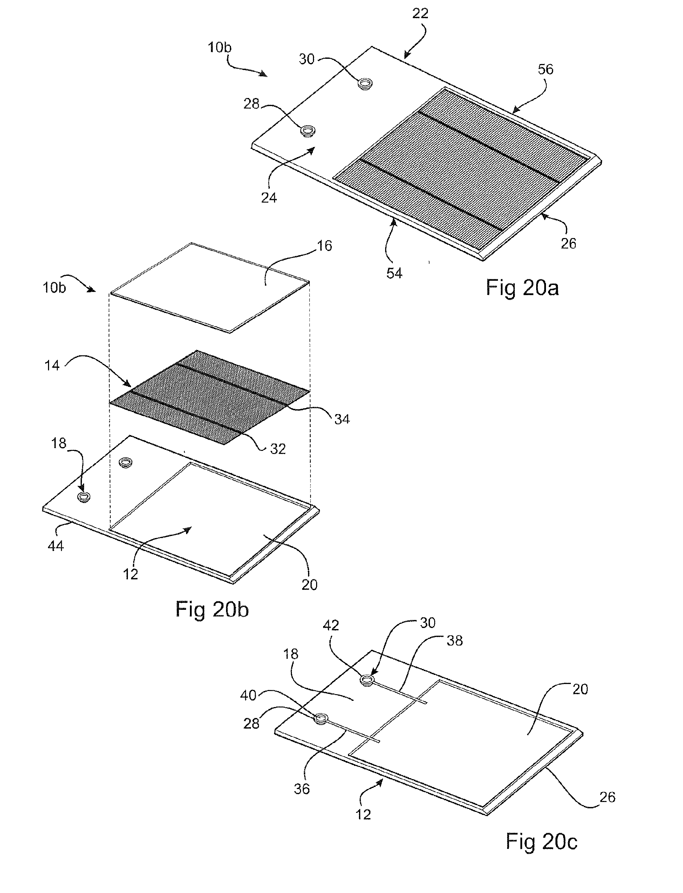

Figures 20a-20c illustrates a second embodiment of the photovoltaic tile denoted as 10B, in which the same reference numbers are used to denote the same features. As is apparent from a comparison of with Figures 19a-19c the two embodiments are very similar and according only the differences in these embodiments will be described.

In essence the main difference between the embodiments is that the cover plate 16 in the photovoltaic tile 10B is smaller and in particular is dimensioned to seat in the recess 20. As a consequence of this the recess 20 is made deeper with the combined thickness of the cover plate 16 and the photovoltaic cell 14 being about the same as the depth of the recess 20. This results in the photovoltaic tile 10B maintaining the flat upper surface 24 described above in relation to the photovoltaic tile 10B. Also, because the cover plate 16 is seated in the recess 20, the curved of beveled profile of the lower edge 26 of the tile 10B is now provided on the carrier tile 12.

The terminals 28 and 30 and the bus bars 36 and 38 are embedded in the photovoltaic tile 10B by being embedded and more particularly molded in the carrier tile 12. For example, the terminals 28 and 30 and a portion of the length of their attached bus bars 36 and 38 can be moulded into the carrier tile 12 during the formation of the carrier tile 12. However, a distal end of each bus bar extends into the recess 20 and is left free to enable connection with the photovoltaic cell 14. The cover plate 16 may also be made of a transparent plastics material.

The operation and use of both embodiments of the photovoltaic tiles 10 and 10B is identical. According for the sake of simplicity the operation and use thereof is described hereinafter with reference to the tile 10 only.

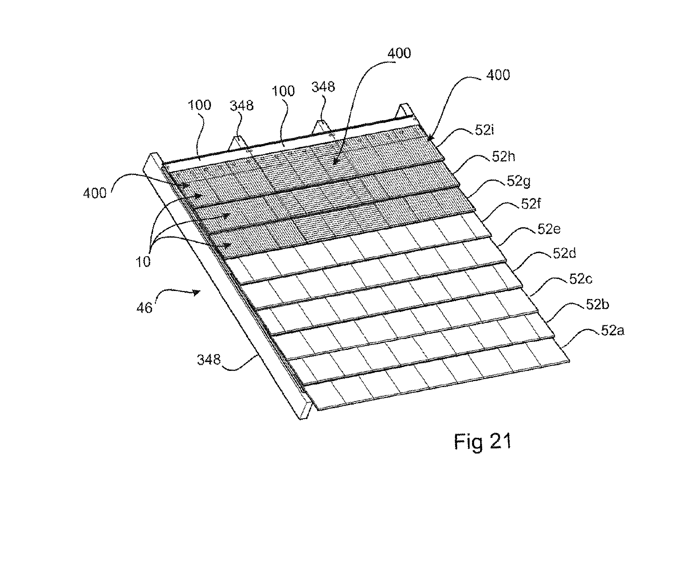

Figure 21 illustrates an array of solar electric panels 400 and a corresponding array of photovoltaic tiles 10 overlying and coupled to a roof structure 300 which comprise a plurality of parallel roof rafters 348. As previously described, the photovoltaic tiles 10 are connected to an underlying corresponding base tiles 100 which in turn are fastened to the underlying rafters 348. Hooks 302 (see fig. 8) similar to conventional slate hooks can be used if required to further assist in supporting and holding down the photovoltaic tiles 10.

The photovoltaic tiles 10 are arranged in successive rows 52a-52i, with row 52a being lowermost. Successive rows are staggered by half a photovoltaic tile 10 width relative to the underlying row. Further, a higher row partially overlies an adjacent underlying row. For example, the photovoltaic tiles 10 in the row 52b overlie the photovoltaic tiles 10 in the row 52a. More particularly, the photovoltaic tiles 10 in a higher row overlie portion 44 of the photovoltaic tiles 10 in an underlying row. This arrangement of photovoltaic tiles 10 provides the roof structure 46 with a roof covering that has a geometric appearance of a slate or shingle roof. This appearance is enhanced by the slate-like appearance and colouring of the photovoltaic tiles 10.

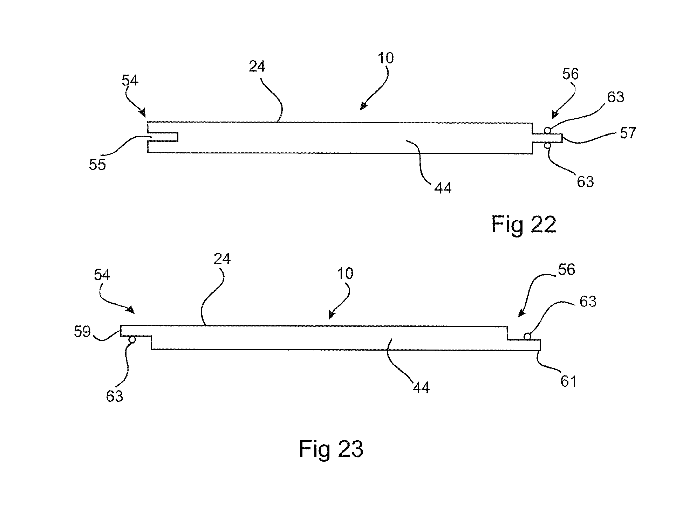

In their simplest form opposite longitudinal side faces of the photovoltaic tiles 10 are flat and abut against the side face of an adjacent tile 10. If waterproof sealing is required a bead of sealant material can be laid between or over the abutting surfaces. However in an alternate embodiment, as shown in Figures 22 and 23 opposite longitudinal sides 54 and 56 of each photovoltaic tile 10 can be formed with sealing structures or components which when mutually engaged form a waterproof seal between adjacent photovoltaic tiles 10 in any particular row 52. That is, the side 56 on one photovoltaic tile 10 can engage and form a seal with the longitudinal side 54 of an adjacent photovoltaic tile 10. This may be achieved in several different ways. For example, Figure 22 depicts a cross section of a tile 10 through portion 44, where the side 54 is formed with a longitudinal groove 55 and the side 56 with a longitudinal and laterally extending tongue 57 that fits into the groove and forms a seal therewith. In an alternative arrangement shown in figure 23 the side 54 is formed with a laterally extending lip 59 of one half the thickness of the photovoltaic tile 10 and extending flush with the surface 24, while the side 54 is provided with a complementary lip 61 also of half the thickness of the photovoltaic tile 10 but flush with a bottom surface of the carrier tile 12 so that the side 56 of one photovoltaic tile 10 can overlie the side 54 of an adjacent photovoltaic tile 10 to form a waterproof seal. The sealing effect in both arrangements may be enhanced by the provision of one or more rubber seals 63 acting between the tongue 57 and groove 59 in the first instance, and the overlying lips 61, 63 in the second instance.

Figure 19a depicts a photovoltaic tile 10 with eighteen photovoltaic cells 14 arranged in a 3x6 matrix. The specific number of cells 14 per photovoltaic tile 10, and the manner in which the cells are connected within the tile 10, as well as the number of tiles 10 connected with each base tile 100 and the manner in which the tiles 10 are electrically connected is dependent on numerous design considerations. These include, but are not limited to:
(a) the nature of the load to be driven by the photovoltaic tiles 10, in particular any minimum voltage and/or current requirements;
(b) the shape and configuration of the photovoltaic cells 14 as manufactured and how the cells can tessellate on a carrier tile 12; and
(c) the effects of shadowing on a cell 14.

For example, in the event that solar panels 400 and thus the photovoltaic tiles 10 are to be used to provide sufficient voltage to drive a common indoor grid inverter, it is appropriate that the cells 14 be arranged and connected in a manner to produce a maximum voltage in the order of 180 volts. Consider for example a typical off-the-shelf multi-crystalline photovoltaic cell produces a maximum voltage of approximately .5 of a volt. The current produced is dependent upon the size or area of the cell. In order to generate 180 volts, clearly a number of cells 14 need to be connected together. In determining the best way to produce a voltage of approximately 180 volts one needs to consider trade-offs between:
(i) having a large area with photovoltaic cells connected in series which may adversely suffer from reduced power output if one of the series connected cells does not receive full illumination due to the shadow effect (i.e. due a shadow case by a surrounding building or by virtue of foreign opaque objects such as leaves and/or bird droppings);
(ii) having a smaller area of photovoltaic cells connected in series which is less affected by the shadow effect, however produces higher voltage which may give rise to safety concerns and produce a current that may not be sufficiently high enough for the required load and/or associated energy management system.

One specific configuration of solar electric panel 400 which appears to be well suited to driving a typical indoor grid inverter having a MPPT range of 150+ volts comprises nine series connected photovoltaic tiles 10 arranged as a 3x3 matrix on a base tile 100 where each photovoltaic tile 10 nine photovoltaic cells 14 arranged in a 3x3 series connected matrix. Here the connection system 200a shown in Figures 17 and 18 is used to provide a series connection between each of the photovoltaic tiles 10. In such a configuration each solar electric panel 400 produces an output voltage of approximately 41 volts and a current of approximately 1.25amps. By connecting five solar electric panels 400 together in series an output voltage of approximately 180 volts is achieved. If each base tile 100 (and thus solar electric panel 400) has dimensions of 600x600mm, then the area of a roof required to generate approximately 180 volts is 600x3000mm where five of the solar electric panel 400 are placed side by side.

It is to be understood, however, that this is not the only configuration possible in order to generate sufficient voltage to drive the inverter in question. Other configurations are also possible such as, for example, one where each photovoltaic tile 10 carries ten series connected photovoltaic cells 14 arranged in a 2x5 matrix and where each solar electric panel 400 carries nine series connected tiles 10. In that event, each tile 10 produces approximately 5 volts, and thus each base tile 100 produces approximately 45 volts, in which case four series connected solar electric panel 400 are required to generate approximately 180 volts.

In a further alternate, each photovoltaic tile 10 may carry say 25 photovoltaic cells 14 arranged in a 5x5 matrix. In this case, each tile 10 would produce approximately 12.7 volts and thus each solar electric panel 400 having nine series connected photovoltaic tiles 10 produces approximately 114 volts in which case two series connected base tiles 100 are required to achieve a 180 volt output.

In the above described configurations each photovoltaic tile 10 comprises a plurality of photovoltaic cells 14. This requires cutting and thus wastage of the cells. In a further variation each photovoltaic tile 10 may comprise a single uncut photovoltaic cell. With a parallel connection between the photovoltaic tiles 10 on each base tile 100 using for example the connection system 200 depicted in Figures 1, 10 and 13, each base tile would produce an output voltage of approximately 4.6 volts and current of approximately 5.1 amps. Thus to achieve an output voltage of at least 180 volts forty series connected base tiles are required. With the connection system as shown in Figures 17 and 18, each base tile would produce an output voltage of approximately 4.5 volts and current of approximately 5.1 amps. Thus to achieve an output voltage of at least 180 volts forty series connected base tiles are required.

The carrier tile 12 is described and illustrated as comprising a single recess 20 for seating a single photovoltaic cell 14. However, multiple recesses may be formed each seating separate smaller photovoltaic cells. Further, the terminals 28 and 30 are depicted as separate through hole terminals in the carrier tile 12. However, in an alternate form the terminals 28 and 30 may be formed concentrically with each other whereby electrical connection can be achieved by the use of a co-axial single pin connector. Conversely, if desired more than two terminals may be provided on a tile 10, for example, two positive and two negative terminals where the terminals of the same polarity are connected in parallel to the photovoltaic cell 14. This provides a degree of redundancy in the event of the failure of one connector, as well as providing greater mechanical coupling of the photovoltaic tile 10 to a base tile 100.

### Bypass 42

The bypass 42 reduces the drop in output voltage of a photovoltaic tile 10 and thus the panel 400 in the event that a group of one or more bypassed cells 12 are shadowed to the extent that they are in effect or tend toward an open circuit. Without the bypass an open circuit cell 12 will result in the total circuit output in which the cell is series connected providing a zero voltage output. This is explained in greater detail below.

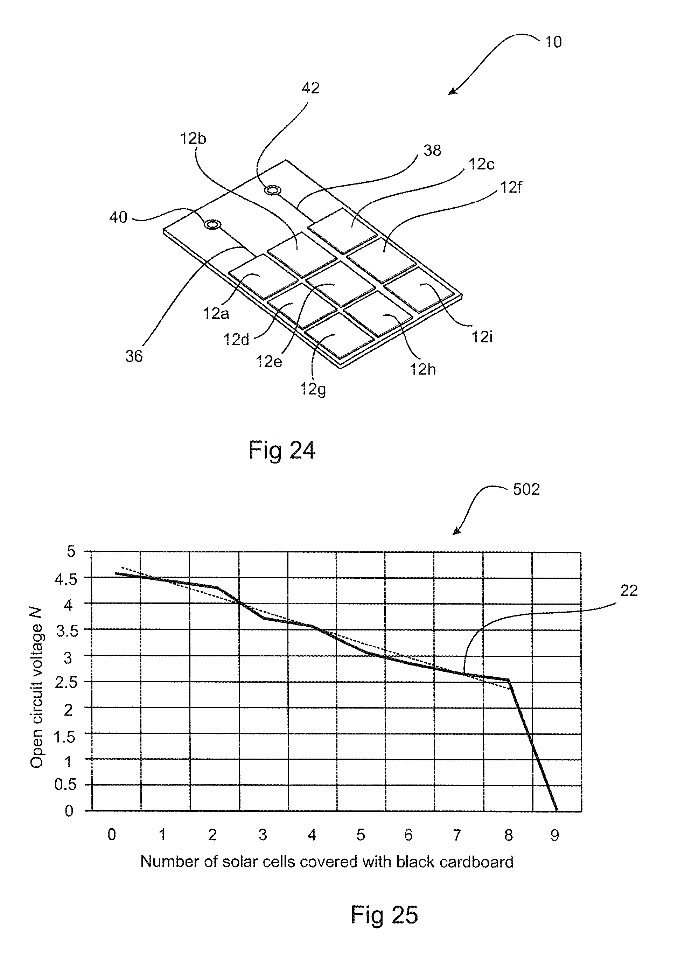

Figure 24 depicts a photovoltaic tile 10 comprising a plurality of photovoltaic cells 12a-12i (hereinafter referred to in general as 'photovoltaic cells 12' or 'cells 12') connected together in series. A first and last of the series connected photovoltaic cells 12 are electrically coupled by respective bus bars 36 and 38 to electrical terminals 40 and 42. The series connected cells 12 form a photovoltaic cell circuit 500.

Figure 25 shows a graph 502 displaying an open circuit voltage of the photovoltaic cell circuit 500 as a function of the number of photovoltaic cells 12 shaded from an impinging light source. It can be seen that the open circuit voltage reduces in a substantially linear fashion as the photovoltaic cells 12 are progressively shaded.

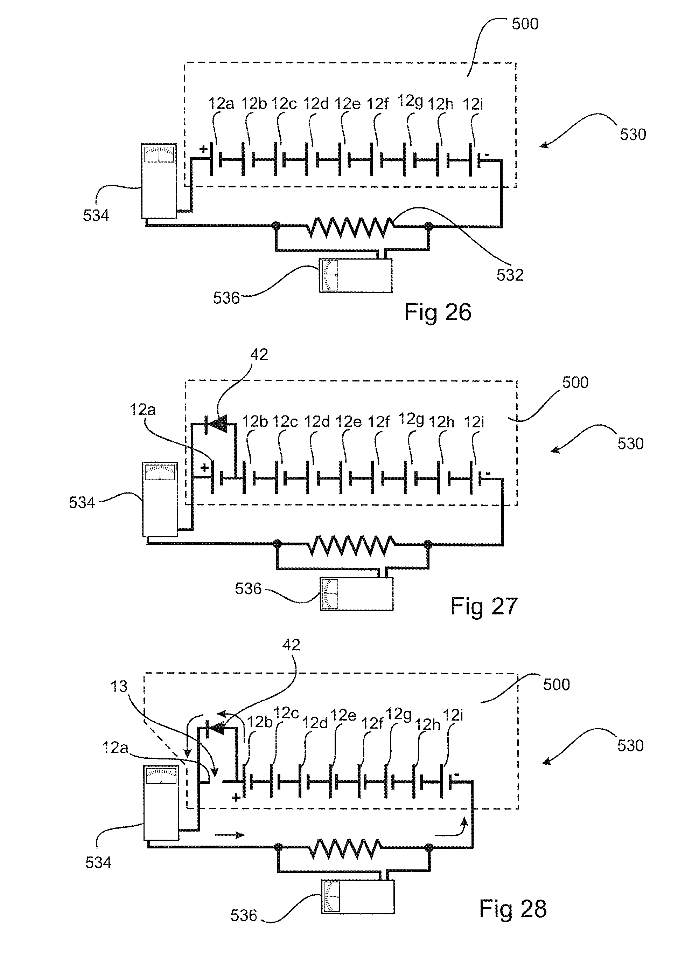

Figure 26 shows a test circuit 530 for the photovoltaic cell circuit 500. The test circuit 530 comprises a series connected load 532 and a first multimeter 534 to measure the current flowing through the load 532 and hence the test circuit 530. A second multimeter 536 is connected in parallel with the load 532 so as to measure the voltage across the load 532.

The test circuit 530 was used in an experiment conducted to test the effects of shading photovoltaic cells 12 from impinging light. The current flowing through and the voltage drop across the load 532 were measured by the first and second multimeters 534, 536 respectively. From these measurements, the power drawn by the load 532 was calculated. In this example and the examples that follow, the load resistance was 33.3Ω.

In a first test, no photovoltaic cells 12 were shaded from impinging light. The current, voltage and power of the load 32 were found to be:

| Diode connected across photovoltaic cell (s) : | Shaded photovoltaic cell (s) : | Voltage across load 32 (V) | Current through load 32 (mA) | Power drawn by load 32 (mW) |
|---|---|---|---|---|
| (no diode connected) | None | 2.8 | 85.5 | 239.4 |

In a second test, the photovoltaic cell 12a was shaded from impinging light. Under these conditions the current, voltage and power of the load 532 were found to be:

| Diode connected across photovoltaic cell (s) : | Shaded photovoltaic cell (s) : | Voltage across load 32 (V) | Current through load 32 (mA) | Power drawn by load 32 (mW) |
|---|---|---|---|---|
| (no diode connected) | 12a | 0.246 | 7.4 | 1.8204 |

In the second test it can be seen that shading one photovoltaic cell 12 caused the total power output to drop to 0.76% of the power output when no photovoltaic cells 12 were shaded.

Figure 27 shows the photovoltaic cell circuit 500 connected in the same test circuit 530, but with a bypass device in the form of a diode 42 shunted across the photovoltaic cell 12a (constituting a group of one cells 12). The diode 42 is reverse biased with respect to photovoltaic cell 12a. If photovoltaic cell 12a is shaded from impinging light, the photovoltaic cell 12a acts as a substantial open circuit but the diode 42 provides an alternate pathway (i.e. a bypass) for the current to flow through the circuit as shown in Figure 28. This leads to less power loss than the situation described with reference to Figure 26 where photovoltaic cell 12a was shaded from impinging light and a diode or other switching device was not present.

The effectiveness of various forms of the bypass is illustrated using the test circuit 530 and explained below. Initially, no photovoltaic cells 12 in the photovoltaic cell circuit 40 were shaded from impinging light. Current and voltage measurements were taken of the load 532 by the first and second multimeters 534, 536 respectively. The current, voltage and power of the load 32 were found to be:

| Diode connected across photovoltaic cell (s) : | Shaded photovoltaic cell (s) : | Voltage across load 32 (V) | Current through load 32 (mA) | Power drawn by load 32 (mW) |
|---|---|---|---|---|
| 12a | None | 2.49 | 81.3 | 202.437 |

Figure 28 shows the photovoltaic cell circuit 500 where the photovoltaic cell 12a has been shaded from impinging light. This has effectively caused the photovoltaic cell 12a to become an open circuit 13. In this situation, the diode 42 is forward biased with respect to the remaining eight photovoltaic cells 12 and so current is able to flow through the diode 42. The current, voltage and power of the load 32 were found to be:

| Diode connected across photovoltaic cell (s) : | Shaded photovoltaic cell (s) : | Voltage across load 32 (V) | Current through load 32 (mA) | Power drawn by load 32 (mW) |
|---|---|---|---|---|
| 12a | 12a | 1.82 | 54.5 | 99.19 |

This represents a power output of 41.4% compared to the configuration where no photovoltaic cells 12 were shaded from impinging light and no diode was present.

Further experiments were conducted where various photovoltaic cells 12 were shaded from impinging light and where the diode 42 was connected in parallel with various photovoltaic cells 12. A table of results displaying the outcomes of some of these experiments is shown below:

| Diode connected across photovoltaic cell (s) : | Shaded photovoltaic cell(s): | Voltage across load 32 (V) | Current through load 32 (mA) | Power drawn by load 32 (mW) |
|---|---|---|---|---|
| (no diode connected) | None | 2.8 | 85.5 | 239.4 |
| (no diode connected) | 12a | 0.246 | 7.4 | 1.8204 |
| 12a | None | 2.49 | 81.73 | 202.437 |
| 12a | 12a | 1.82 | 54.5 | 99.19 |
| (no diode connected) | 12a, 12b | 0.066 | 2 | 0.132 |
| 12a, 12b | None | 2.46 | 75.5 | 183.27 |
| 12a, 12b | 12a | 1.5 | 45 | 67.5 |
| 12a, 12b | 12a, 12b | 1.6 | 48.7 | 77.92 |
| (no diode connected) | 12a, 12b, 12c | 0.031 | 0.9 | 0.0279 |
| 12a, 12b, 12c | None | 2.15 | 63.5 | 136.525 |
| 12a, 12b, 12c | 12a | 1.1 | 33.4 | 36.74 |
| 12a, 12b, 12c | 12a, 12b | 1.26 | 38.7 | 48.762 |
| 12a, 12b, 12c | 12a, 12b, 12c | 1.23 | 37 | 45.51 |
| 12a, 12b, 12c, 12d | None | 2.2 | 67 | 147.4 |
| 12a, 12b, 12c, 12d | 12a | 0.73 | 22 | 16.06 |
| 12a, 12b, 12c, 12d, 12e | 12a | 0.57 | 16.3 | 9.291 |
| 12a, 12b, 12c, 12d, 12e, 12f | 12a | 0.49 | 15.3 | 7.497 |
| 12a, 12b, 12c, 12d, 12e, 12f, 12g | 12a | 0.24 | 6.8 | 1.632 |
| 12a, 12b, 12c, 12d, 12e, 12f, 12g, 12h | 12a | 0.29 | 8.7 | 2.523 |
| 12a, 12b, 12c, 12d | None | 2.24 | 67.8 | 151.872 |
| 12a, 12b, 12c, 12d, 12e | None | 2.07 | 61.5 | 127.305 |
| 12a, 12b, 12c, 12d, 12e, 12f | None | 1.94 | 59.6 | 115.624 |
| 12a, 12b, 12c, 12d, 12e, 12f, 12g | None | 2.29 | 68.8 | 157.552 |
| 12a, 12b, 12c, 12d, 12e, 12f, 12g, 12h | None | 2.19 | 66.4 | 1453416 |
| 12a, 12b, 12c, 12d, 12e, 12f, 12g, 12h, 12i | None | 2.5 | 75 | 187.5 |

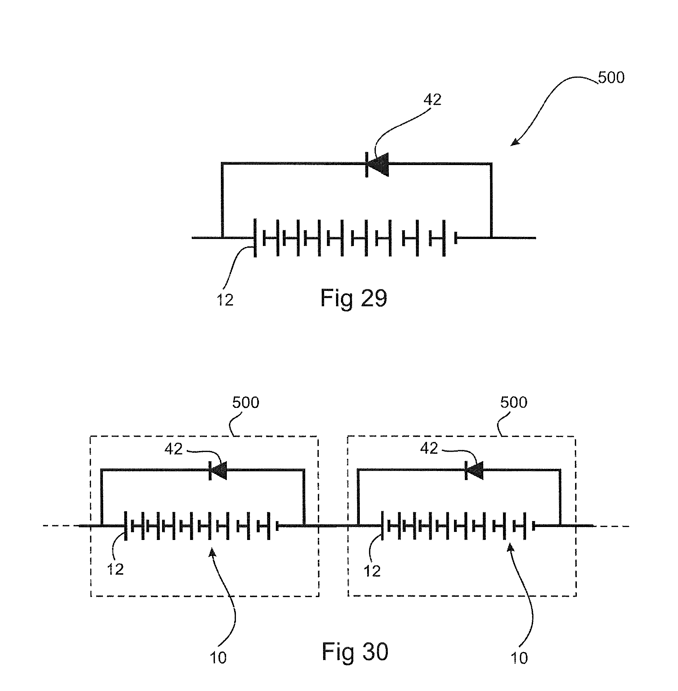

Figure 29 shows the photovoltaic cell circuit 500 where the diode 42 is shunted across all of the cells 12 (i.e. a group of nine cells 12). With reference to Figures 1 and 24, this circuit is realised by placing the diode 42 across the terminals 28 and 30 of the photovoltaic tile 10. The diode 42 is reverse biased with respect to all of the cells 12. In the event that one or more of the cells 12 is shaded from impinging light, the diode 42 can provide an alternate pathway through which current can flow. This can be particularly advantageous when a plurality of photovoltaic cell circuits 500, and specifically a plurality of photovoltaic tiles 10, are connected in series as described below.

The photovoltaic cell circuit 500 may be connected in series with further photovoltaic cell circuits 500 as shown in Figure 30. This is equivalent to the series connecting of photovoltaic tiles 10 where each photovoltaic tile 10 has a diode 42 across their respective terminals 28 and 30. If a cell 12 from any one of the photovoltaic cell circuits 50 is shaded from impinging light, the respective diode 42 of the respective photovoltaic cell circuit 50 can provide an alternate pathway through which current can flow. In this way, the shading of one or more cells 12 from impinging light does not result in as large a power loss than if a diode or other switching device was not connected across each photovoltaic cell circuit 500.

In an alternative embodiment, the diode 42 may be applied across a plurality of photovoltaic cells 12, for example an array of photovoltaic tiles 10 on one or more solar panels 400. This can provide the advantage whereby a higher voltage can be attained to overcome the voltage drop when a constituent photovoltaic cell 12 is shaded from impinging sunlight.

The parallel connection of the diode 42 in each photovoltaic cell circuit 500 localises the adverse effects of one or more of the cells 12 of each photovoltaic cell circuit 500 being shaded from impinging light. The voltage drop across the diode 42 will be negligible if the series connection of photovoltaic cell circuits 500 is generating a sufficiently high voltage, for example in the range of 100V and above. This allows a plurality of series connected photovoltaic cell circuits 500 (i.e. photovoltaic tiles 10) to be used to generate a voltage high enough to, for example, run an inverter while providing a means whereby the shading of light from impinging on one or more cells 12 will not reduce the achievable voltage by as much than if there were no diode or other switching device used.

One or more bypass devices 42 can be connected in parallel with any combination of photovoltaic cells 12 so as to reduce the adverse effect of one or more photovoltaic cells 12 being shaded from impinging light.

In one form of the solar panel 400 the bypass device(s) 42 are thermally insulated, for example from heating by impinging sunlight. In this way, any leakage current of the bypass device 42 which is dependent on temperature can be reduced to some extent. When the photovoltaic tiles 2 are mounted on a roof or form part of a roof solar energy system, the diodes 42 can be insulated from heating due to impinging sunlight by a layer or layers arranged between the diode 42 and the impinging sunlight. The layers may be any one of or a plurality of insulating materials, for example air gaps between components of a photovoltaic tile 10 or any other insulating means. It is envisaged that any form of effective thermal insulation can be used to reduce the leakage current of the diodes 42. Other devices may be used to cool the diodes 42 such as cooling systems, devices arranged to emit thermal radiation away from the diode 42 such as finned metallic radiators, and fans.

While the photovoltaic cell circuit 500 is described as a series connected circuit with a single shunted bypass device, the bypass device 42 may also be applied to photovoltaic cell circuits connected in parallel, or a combination of both series and parallel circuits where a switching device is placed across any number of photovoltaic cells. Further, while the illustrated embodiments incorporate a diode type switching device with a forward voltage drop of equal or less than 0.7V, alternate switching device such as an anti-fuse or a transistor switching device with no, or a similar low forward, voltage drop may be used.

## Claims

1. A solar electric panel comprising:
a base tile;
a plurality of photovoltaic tiles, each photovoltaic tile comprising one or more photovoltaic cells electrically connected together to form a photovoltaic cell circuit;
a connection system supported on the base tile, the connection system electrically connecting the photovoltaic tiles together in groups of two or more photovoltaic tiles, and mechanically coupling the photovoltaic tiles to the base tile, the connection system being configured to facilitate electrical coupling of the base tile with an adjacent base tile; and
at least one bypass device shunted across a set of one or more of the photovoltaic cells in the photovoltaic cell circuit, wherein the bypass device provides a current path for the photovoltaic cell circuit across the set of photovoltaic cells when an output voltage across the set of photovoltaic cells is less than a predetermined threshold voltage.

2. The solar electric panel according to claim 1 wherein connection system comprises:
a plurality of conducting posts, each post having a free end to which the photovoltaic tiles are coupled; and
a plurality of electrical conductors that electrically connect the posts together.

3. The solar electric panel according to claim 2 wherein the electrical connection system comprises a first electrical connector and a complementary second electrical connector wherein the first electrical connector is coupled to an end of the electrical conductor connected to a first of the posts and the second electrical connector is coupled to an end of the electrical conductor connected to a last of the posts whereby the first electrical connector of one electrical connection system can be electrically connected with a second electrical connector of a second electrical connection system to provide electrical continuity between the first and second electrical connection systems.

4. The solar electric panel according to claim 3 wherein one or both of the first and second electrical connectors are provided with a degree of resilience so as to apply a mechanical force between first and second electrical connectors when coupled together, the mechanical force acting to maintain coupling between the first and second electrical connectors.

5. The solar electric panel according claim 4 wherein the first and second electrical connectors are configured to form, when engaged with each other, a mutual contact surface of variable length.

6. The solar electric panel according to any one of claims 2-5 wherein the free end of each post is provided with a fitting to enable mechanical and electrical connection to the photovoltaic tile.

7. The solar electric panel according to claim 6 wherein the fitting comprises a plurality of resilient, or resiliently supported, radially extending projections, formed about the free end of the post.

8. The solar electric panel according to claim 6 wherein the fitting comprises a combination of (a) a screw thread formed on the free end of the post and a nut adapted to be screwed onto the thread, or (b) a screw thread formed in the free end of the post and a screw or bolt adapted to be screwed onto the thread.

9. The solar electric panel according to any one of claims 2-8 wherein the electrical conductors and posts are encapsulated to form an electrical connection tile, wherein the free end of each post is accessible to facilitate connection with the photovoltaic tiles.

10. The solar electric panel according to any one of claims 2-9 wherein each electrical conductor comprises a conducting rail to which a plurality of the posts is connected.

11. The solar electric panel according to any one of claims 2-9 wherein each electrical conductor comprises one or more wires, or one or more conducting tracks on a circuit board.

12. The solar electric panel according to claim 11 wherein the wires or tracks are configured to enable custom connection to the posts to provide selectable connection configurations.

13. The solar electric panel according to claim 12 wherein the wires or tracks are configured to provide a series connection between the one or more first electrical devices or apparatuses.

14. The solar electric panel according to any one of claims 1-8 wherein the base tile is made from a moldable material and the connection system is molded into the substrate.

15. The solar electric panel according to any one of claims 2-13 wherein the base tile comprises a bottom shell defining a cavity in which the connection system is disposed.

16. The solar electric panel according to claim 16 wherein the base tile comprises a top shell which overlies the cavity and is provided with a plurality of holes in alignment with the posts wherein the posts extend toward corresponding holes.

17. The solar electric panel according to any one of claims 1-16 wherein the base tile comprises a plurality of markers on a first surface each marker positioned at a location whereby a mechanical fastener passing through a marker in a plane perpendicular to a plane containing the base tile is spaced from the connection system.

18. The solar electric panel according to any one of claims 1-17 wherein base tile comprises a sealing system for providing a waterproof seal between adjacent abutting base tiles.

19. The solar electric panel according to any one of claims 1-18 wherein the photovoltaic tile comprises:
a carrier tile having a first side; and
a cover plate sealed to the carrier tile, the cover plate having a first side, wherein the carrier tile and the cover plate are relatively configured to form a recess therebetween when cover plate overlies the carrier tile with the respective first sides facing each other, wherein the one or more photovoltaic cells are seated in the recess.

20. The solar electric panel according to claim 19 wherein the photovoltaic tile when viewed from a side provided with the cover plate has a slate-like appearance.

21. The solar electric panel according to claim 19 wherein the carrier tile is of a slate-like colour.

22. The solar electric panel according to claim 21 wherein the photovoltaic cells are of a slate-like colour.

23. The solar electric panel according to any one of claims 19-22 wherein the recess is formed in the first surface of the carrier tile.

24. The solar electric panel according to any one of claims 19-23 wherein the cover plate has substantially the same footprint as the carrier tiles so that respective edges of the carrier tile and cover plate are substantially co-terminus.

25. The solar electric panel according to claim 23 wherein the cover plate is seated in the recess.

26. The solar electric panel according to any one of claims 1-25 wherein the photovoltaic tile comprises one or more through hole electrical terminals by which the photovoltaic tile are electrically and mechanically coupled by the connection system.

27. The solar electric panel according to claim 26 further comprising electrical cell conductors providing an electrical connection between each electrical terminal and the one or more photovoltaic cells.

28. The solar electric panel according to claim 27 wherein the electrical cell conductor are molded into the carrier tile for at least a portion of their length extending from the terminals.

29. The solar electric panel according to any one of claims 1-28 wherein each bypass device comprises a switching device.

30. The solar electric panel according to claim 29 wherein at least one of the bypass devices is a diode.

31. The solar electric panel according to claim 30, wherein at least one diode has a forward voltage drop of equal to or less than 0.7 V.

32. The solar electric panel according to claim 29, wherein at least one switching device is an anti-fuse or a transistor switching device.

33. The solar electric panel according to claim 30 or 31, wherein at least one diode is shunted across one or more of the photovoltaic cells in a manner such that each diode is reverse biased by the one or more photovoltaic cells across which it is shunted.

34. The solar electric panel according any one of claims 1-33 wherein the at least one bypass device is thermally insulated so as to reduce leakage current therefrom.
